# EUROPEAN PATENT SPECIFICATION

(11) **EP 2 186 118 B1**
(45) Date of publication and mention of the grant of the patent: **14.02.2018**
(21) Application number: 07808914.1
(22) Date of filing: 28.08.2007
(51) Int. Cl.: H01L 21/208, H01L 33/00, H01L 21/302, H01L 51/56, H01L 51/00, H01L 27/32

(54) **A METHOD OF MANUFACTURING AN ORGANIC ELECTRONIC OR OPTOELECTRONIC DEVICE**
VERFAHREN ZUR HERSTELLUNG EINES ORGANISCHEN ELEKTRONISCHEN ODER OPTOELEKTRONISCHEN BAUELEMENTS
PROCÉDÉ DE FABRICATION D'UN DISPOSITIF ÉLECTRONIQUE OU OPTOÉLECTRONIQUE ORGANIQUE

(43) Date of publication of application: 19.05.2010
(73) Proprietor: Agency for Science, Technology And Research, Singapore 138632 (SG); Sumitomo Chemical Company, Limited, Tokyo 104-8260 (JP)
(72) Inventor: LOW, Hong Yee, Singapore 117602 (SG); DUMOND, Jarrett, Singapore 117602 (SG); CHONG, Karen, Singapore 117602 (SG); YAMAMOTO, Kyoko, Tokyo 104-8260 (JP); AMAMIYA, Satoshi, Tokyo 104-8260 (JP)
(74) Representative: Regimbeau
(86) International application number: PCT/SG2007/000281
(87) International publication number: WO 2009/029045

(56) References cited:
- EP-A2- 1 806 602
- WO-A1-2004/105104
- WO-A1-2007/046772
- US-A1- 2004 248 419
- US-A1- 2005 074 963
- US-A1- 2006 255 720

## Description

### Technical Field

The present invention generally relates to a method of manufacturing an organic electronic or optoelectronic device.

### Background

Organic electronic or optoelectronic devices generally comprise an active organic material disposed between electrode layers. To obtain functional devices, it is generally necessary to form patterns on the electrodes and/or organic material layers.

A known method to form patterns on the device involves steps such as exposing the device to electromagnetic radiation in order to result in a chemical change in the molecular structure, developing the pattern through chemical etching and removing the etched materials. However, there are a number of disadvantages associated with the above method. Firstly, exposure to electromagnetic radiation, such as ultraviolet light, may result in unwanted degradation of the device. Secondly, chemical etching may result in unwanted contamination of the device through the use of chemicals. Thirdly, this method requires numerous steps and increases manufacturing time and costs.

An alternative method involves the use of inkjet printing technology to fabricate organic electronic devices and optoelectronic devices. Inkjet printing involves the deposition, using an inkjet spray head, of an organic solution onto a surface of a substrate to deposit an organic compound thereon having desirable properties. As it is a modification of an existing technology, inkjet printing is seen as a potentially low cost technique for the fabrication of organic transistors^{1,2} and displays^{3,4}. EP 1 806 602 A2 discloses a method of manufacturing a black matrix for colour filters where the top surface of the black matrix has a plurality of nano-sized grooves making said top surface of the black matrix ink-phobic.
WO 2007/046772 A1 discloses a method of forming a grating structure having bank structures that have nano-sized structures on top of said banks. However, an impediment to the successful implementation of this technology is the control of the spreading of the solvent present within the organic liquid deposited by the inkjet head. For example, the spreading of the solvent can result in limited pattern resolution of about 30 µm.

In the fabrication of substrates having multicomponent parts, the spreading of the solvent is a particular problem as it may result in cross-contamination between different component parts of the substrate. To overcome this problem, the substrate has been divided up by a series of banks having wells disposed therebetween. The bank and wells being pre-patterned onto the substrate to allow the organic liquid to be printed onto the substrate and thereby reside in a particular well. Hence, the banks act as a physical barrier to prevent movement of deposited solution to other parts of the substrate. However, due to restrictions in the accuracy of inkjet printing technologies, some organic solution may inadvertently be deposited onto a bank surface rather than within a well. This may result in spreading of the organic solution to unwanted parts of the substrate. Furthermore, the properties of the organic solution deposited in a well may cause it to spread onto an adjacent bank surface.

There is a need to provide a method of manufacturing an organic electronic or optoelectronic device that overcomes, or at least ameliorates, one or more of the disadvantages described above.

### Summary

According to a first aspect, there is provided a method of manufacturing an organic electronic or optoelectronic device, the method comprising the steps of:
a) providing a substrate having a plurality of banks formed thereon with alternating well formations formed therebetween, the surface of said banks having imprint formations formed thereon, wherein the imprint formations confer an anisotropic wetting property to the surface of said banks that is different from the surface of said wells; and
b) depositing an organic solution into said well formations, wherein the anisotropic wetting property of said surface of the banks causes any organic solution deposited on an area other than said well formations to be at least partially repelled.

Advantageously, the at least partial repulsion of said organic solution from said bank surface inhibits deposition of said organic solution from areas on the surface of the substrate other than in said wells. Hence, the method controls the spreading of an organic solution from surfaces on the substrate, namely the bank surfaces, in which it is not desired to deposit the organic solution. More advantageously, the method allows more direct deposition of organic solution onto desired areas of a substrate, thereby allowing inkjet printing technology to be used in organic electronic or optoelectronic device manufacture.

Advantageously, the method may confer a selected wetting property to the banks on the substrate surface while optionally excluding chemically treatment of said surface.

Advantageously, the method may confer a selected wetting property to the banks on the substrate surface while not affecting at least one of the thermal, chemical and optical properties of the substrate.

According to a second aspect, there is provided a method of making a substrate comprising the steps of:
a) providing a substrate having a polymer layer formed thereon; and
b) applying at least one mold to said polymer layer to form a plurality of banks thereon with alternating well formations formed between said banks, said at least one mold having imprint forming surfaces thereon to form imprint formations on said bank surface which confer an anisotropic wetting property to the surface of said banks that is different from the surface of said wells.

According to a third aspect, there is provided a substrate for use in an organic electronic or optoelectronic device having a plurality of banks formed thereon with alternating well formations formed therebetween, the surface of said banks having imprint formations formed thereon, wherein the imprint formations confer an anisotropic wetting property to the surface of said banks that is different from the surface of said wells, wherein when an organic solution is deposited on an area other than said well formations, the anisotropic wetting property of said banks causes any organic solution deposited thereon to be at least partially repelled.

### Definitions

The following words and terms used herein shall have the meaning indicated:
The term 'organic electronic device' is to be interpreted broadly to include any electronic device that utilizes an organic compound, typically in the form of an organic layer, as an active material that is integral in the operation of the organic device. Exemplary organic electronic devices include, but are not limited to, organic light emitting devices (OLEDs), polymer light emitting devices (PLEDs), organic transistors and organic photovoltaic devices. In the case of OLEDs or PLEDs, the organic compound may be selected from the group consisting of light emitting organic molecule, light emitting polymer, conductive polymer with hole-transporting properties, an organic material with electron transporting properties, and combinations thereof. In the case of organic transistors, the organic compound may be a conductive polymer. In the case of an organic photovoltaic device, the organic compound may be selected from the group consisting of light absorbing polymer, conductive polymer and combinations thereof.

The term 'organic optoelectronic device' is to be interpreted broadly to include any electronic device that utilizes an organic compound, typically in the form of an organic layer, as an active material that is responsive to light or is able to emit light. For example, the organic compound may be a light emitting polymer in that it is able to emit light when excited by an electrical current. Examples include OLEDs such as those disclosed in United States Patent Nos 5,952,778, 6,885,025 and 6,586,876, and PLEDs such as those disclosed in 6403236 and 5980781. Alternatively, the organic compound may be responsive to light in that it absorbs light and converts it to electrical energy. Examples include polymer solar cells such as those disclosed in US Patent No. 5,986,206 and United States Patent Application No. 20050284513.

The term 'conductive polymer' is to be interpreted broadly to include any polymer that acts as a semiconductor, whereby the electrical conductivity of such polymers is between those of typical metals (conductors) and electrical insulators. Typically, the surface resistivity of a conductive polymer ranges from 10¹ to 10⁷ ohms/square. As is known in the art, there are two classes of conductive polymers: charge transfer complexes and conductive polyacetylenes. The term 'conductive polymer' also includes any polymer that has been suitably doped with electrically conductive additives in order to create or enhance the electrical conductivity ability of a polymer that is a non-conductor or a poor conductor initially. Furthermore, a conductive polymer may have electroluminescent properties.

The term 'light emitting polymer' is to be interpreted broadly to include any polymer that is capable of emitting light when excited. The excitation of the light emitting polymer may be due to the passage of an electric current through the polymer. It is to be appreciated that kinds of light emitting polymers are known in the art. Exemplary light emitting polymers are discussed in US Patent number 7166239.

The term 'light absorbing polymer' is to be interpreted broadly to include any polymer that is capable of absorbing light and converting the light energy to electrical energy. Light absorbing polymers are also termed as photovoltaic polymers. A detailed mechanism of how photovoltaic polymers work and examples of such polymers are discussed in "Conjugated Polymers: New Materials for Photovoltaics" by G. G. Wallace et al in Chemical Innovation, Volume 30, No. 1, pages 14 to 22, 2000.

The term 'organic solution' is to be interpreted broadly to refer to a substantially homogeneous mixture of an organic compound in a suitable solvent. As mentioned above, the organic compound depends on the type of device it is suitable for and may be a light emitting organic molecule, a light emitting polymer, a light absorbing polymer, a conductive polymer with hole-transporting properties or an organic material with electron transporting properties. The organic solution may be filtered to remove any insoluble organic compound that may be present in order to facilitate downstream processing. The organic solution may comprise suitable additives that substantially improve the properties of the organic solution. Such properties may include, but are not limited to, printability, solubility, viscosity or performance of the organic solution. A suitable method of making an organic solution is discussed in US Patent Number 7,115,216. It is to be appreciated that the choice of the solvent may be dependent on the type of organic compound to be dissolved and such solvents are known to a person skilled in the art.

The term 'wettingproperty' when applied to a surface is to be interpreted broadly to include any property of a surface that allows or disallows the spreading of a test liquid droplet on the surface. This spreading of a test liquid droplet depends on the roughness and surface energy. Wetting property of a surface can be determined by measuring the contact angle between the liquid droplet and the solid surface. Depending on the values of the contact angles and the directions of measurement, isotropic or anisotropic wetting property of a surface can be interpreted as liquidphobic or liquidphilic. Generally, the spreading and hence wetting behaviour of a liquid droplet can be modeled according to the Wenzel equation (see *"*Resistance of Solid Surfaces to Wetting by Water" by R. N. Wenzel, Industrial and Engineering Chemistry, 1936, 28 (8), page 988*)*) or the Cassie equation (see *"*Contact Angle" by A. B. D. Cassie, Discussions of the Faraday Society, 1948, 3, page 11). However, in some cases, the behaviour may be modeled according to a modified form(s) of the equation(s), which are known to those skilled in the art.

The term 'wetting ability' when applied to a liquid is to be interpreted broadly to refer to the ability of a liquid to freely wet the surface of a solid. The wetting ability of a liquid depends on the surface energies at the solid-gas interface, the liquid-gas interface, and the solid-liquid interface. When a drop of liquid is placed on a solid surface, one of two situations occurs. In the first situation, if the liquid molecules have a stronger attraction to the solid molecules on the surface of the object as compared to each other, the liquid will wet the surface. However, in the second situation, the converse happens and the liquid will tend to form beads on the surface and will not wet the solid surface. By measuring the contact angle of a liquid droplet placed on the solid surface, the wetting ability of a liquid may be determined.

The term "contact angle", in the context of this specification, is to be interpreted broadly to include any angle that is measured between a liquid/solid interface. The contact angle is system specific and depends on the interfacial surface tension of the liquid/solid interface. A discussion on contact angle and its relation to surface wetting properties can be seen from "Wettability, Spreading, and Interfacial Phenomena in High-Temperature Coatings" by R. Asthana and N. Sobczak, JOM-e, 2000, 52 (1*)*. The contact angle can be measured from two directions. In the context of this specification, for a longitudinal imprint being disposed about a longitudinal axis, θx refers to the contact angle measured in the "X" direction being perpendicular to the longitudinal axis and θy refers to the contact angle measured in the "Y" direction parallel, or in alignment with, the longitudinal axis. The value of the contact angle, θx or θy, may indicate the liquidphobicity or liquidphilicity of a surface. The difference of these two contact angles, represented by Δθ (where Δθ = θy - θx), indicates the degree of isotropy or anisotropy of a wetting property.

The terms "liquidphobic" and "liquidphobicity" when referring to a surface are to be interpreted broadly to include any property of a surface that does not cause a liquid droplet to substantially spread across it. Generally, if the contact angle between a liquid droplet and the surface is greater than 90°, the surface is liquidphobic or exhibits liquidphobicity. Likewise, the terms "hydrophobic" and "hydrophobicity" mean that the surface is liquidphobic or exhibits liquidphobicity when water is the liquid placed thereon. If the contact angle between a water droplet and the surface is greater than 150°, the surface is defined as superhydrophobic. The terms 'liquidphobic' and 'liquidphobicity' may also be used to refer to the wetting ability of a liquid. A liquid that does not substantially wet the surface of a solid that it is placed on is termed as a liquidphobic liquid.

The terms "liquidphilic" or "liquidphilicity" when referring to a surface are to be interpreted broadly to include any property of a surface that causes a liquid droplet to substantially spread across it. Generally, if the contact angle between a liquid droplet and the surface is smaller than 90°, the surface is liquidphilic. Likewise, the terms "hydrophilic" and "hydrophilicity" mean that the surface is liquidphilic or exhibits liquidphilicity when water is the liquid placed thereon. If the contact angle between a water droplet and the surface is about 0°, the surface is defined as superhydrophilic. The terms 'liquidphilic' and 'liquidphilicity' may also be used to refer to the wetting ability of a liquid. A liquid that substantially wets the surface of a solid that it is placed on is termed as a liquidphilic liquid.

The terms "isotropic" or "isotropy" when referring to a wetting property or wetting ability means that a liquid droplet has similar values of apparent contact angles when measured from different directions. Generally, the contact angles are measured from two directions, wherein the two directions are perpendicular to each other (ie X direction and Y direction as defined above). The smaller the difference between the two contact angle values, the greater the degree of isotropy.

The terms "anisotropic" or "anisotropy" when referring to a wetting property or wetting ability means that a liquid droplet has different values of apparent contact angles when measured from different directions. Generally, the contact angles are measured from two directions (ie X direction and Y direction as defined above), wherein the two directions are perpendicular to each other. The greater the difference between the two contact angle values, the greater the degree of anisotropy.

The terms "nano/micro-imprinting lithography" is to be interpreted broadly to include any method for printing or creating a pattern or structure on the micro/nanoscale on the surface of a substrate by applying a mold with the defined pattern or structure on the surface at certain temperatures and pressures. A method of micro/nanoimprinting lithography can be referred from US Patent Number 5,772,905.

The term "microscale" is to be interpreted to include any dimensions that are in the range of about 1 (µm) to about 100 µm. The term "microstructures" as used herein, refers to structures comprising "microscale" features.

The term "nanoscale" is to be interpreted to include any dimensions that are below about 1 µm. The term "nanostructures" as used herein, are structures comprising "nanoscale" or "submicron" features.

The term "three dimensional" is to be interpreted broadly to include any structures, structural features, imprints or patterns that have both lateral variations (thickness) as well as variations with depth.

The term "hierarchical" is to be interpreted broadly to include any relevant steps that are carried out in a serial manner. For example, the term "hierarchical nanoimprinting" refers to the sequential application of nano-sized imprints on a surface of a polymer substrate. In one embodiment, hierarchical nano/micro-imprinting is carried out using two molds that are applied to the surface of the substrate separately one after the other. In other embodiments, more than two molds can be used to create a complex hierarchical structure. Typically, the subsequent imprints have smaller dimensions when compared to the preceding imprint so that the hierarchical structure exhibits a variation in size along the height of the imprint, that is, along the z-direction.

The term "glass transition temperature" (T_{g}) is to be interpreted to include any temperature of a polymer at which the polymer lies between the rubbery and glass states. This means that above the T_{g}, the polymer becomes rubbery and can undergo elastic or plastic deformation without fracture. Above this temperature, such polymers can be induced to flow under pressure. When the temperature of the polymer falls below the T_{g}, generally, the polymer will become inflexible and brittle such that it will break when a stress is applied to the polymer. It should be noted that the T_{g} is not a sharp transition temperature but a gradual transition and is subject to some variation depending on the experimental conditions (e.g., film thickness, tacticity of the polymer, etc.). The actual T_{g} of a polymer film will vary as a function of film thickness. The T_{g} will be defined herein as being the bulk glass-transition temperature of the polymer substrate. The bulk glass transition temperature is a specific value that is widely agreed upon in the literature. Glass transition temperature values of polymers may be obtained from PPP Handbook™ software edited by Dr D. T. Wu, 2000*.*

The term "plasma treatment" is to be interpreted broadly to include any exposure of a surface to plasma such that organic contaminants on the surface are at least partially destroyed. Generally, such plasma is low-pressure oxidative plasma such as oxygen (O₂), argon, and mixtures of oxygen and argon, generated with a radio frequency (RF) or microwave source.

The term "substantially" does not exclude "completely" e.g. a composition which is "substantially free" from Y may be completely free from Y. Where necessary, the word "substantially" may be omitted from the definition of the invention.

Unless specified otherwise, the terms "comprising" and "comprise", and grammatical variants thereof, are intended to represent "open" or "inclusive" language such that they include recited elements but also permit inclusion of additional, unrecited elements.

As used herein, the term "about", typically means +/-5% of the stated value, more typically +/- 4% of the stated value, more typically +/- 3% of the stated value, more typically, +/- 2% of the stated value, even more typically +/- 1% of the stated value, and even more typically +/- 0.5% of the stated value.

Throughout this disclosure, certain embodiments may be disclosed in a range format. It should be understood that the description in range format is merely for convenience and brevity and should not be construed as an inflexible limitation on the scope of the disclosed ranges.

### Disclosure of Optional Embodiments

Exemplary, non-limiting embodiments of a method of manufacturing an organic electronic or optoelectronic device will now be disclosed.

The method comprises the steps of: (a) providing a substrate having a plurality of banks formed thereon with alternating well formations formed therebetween, the surface of the banks having imprint formations formed thereon, wherein the imprint formations confer an anisotropic wetting property to the surface of the banks that is different from the surface of the wells; and (b) depositing an organic solution into the well formations, wherein the anisotropic wetting property of said surface of the banks causes any organic solution deposited thereon to be at least partially repelled.

The imprint formations may be generally longitudinal in shape, wherein each imprint formation extends about a longitudinal axis. The imprint formations may comprise a first set of imprint formations extending along longitudinal axes that are parallel to each other and a second set of imprint formations extending along longitudinal axes that are parallel to each other.

The angle between the longitudinal axes of the first set of imprint formations and the longitudinal axes of the second set of imprint formations may be in the range selected from the group consisting of about 0° to about 90°, about 0° to about 45° and about 45° to about 90°.

The banks may be made of a polymeric material although any material that is capable of being imprinted by a mold can be used.

The method may comprise the step of selecting a thermoplastic, polymer as the polymeric material for the banks. Exemplary thermoplastic polymers may be selected from the group consisting of polymethylmethacrylate, polycarbonate, polystyrene, cycloolefinpolymer, polyimide and combinations thereof.

In another embodiment, the polymeric material may be a photoresist or a photosensitive polymer. The photoresist may be of the negative working type or positive working type. Exemplary photoresist may be made of photopolymerizable monomers such as acrylates (for example, polyfunctional epoxy acrylate or polyfunctional acrylate) and epoxy resins; or composition such as combination of novolac resin and quinonediazide compound. Exemplary photosensitive polymer may be made of polyimide or cycloolefinpolymer.

Suitable photoresist materials include epoxy based negative resists such as SU-8™ resist available from MicroChem Corp. of Newton, Massachusetts, United States of America.

The polymeric material may be a polymer composite whereby particles may be added to or incorporated with the polymer. These particles may be selected from the group consisting of calcium carbonate, fibers, glass fibers, carbon fibers, carbon nanotubes and mixtures thereof.

It is to be appreciated that the polymeric material used to form the banks should not substantially conduct electricity through the banks. Furthermore, the polymeric material should not substantially react with the organic solution in the wells, the substrate or the circuit board. The polymeric material may be chosen to confer mechanical strength, thermal stability and chemical inertness to the organic solvent.

The polymeric material may first be deposited as a layer on the substrate surface. The polymeric material may be spin-coated onto the substrate surface.

The method may comprise the step of nano/micro-imprinting lithography to create hierarchical structures on the substrate surface.

The method may comprise the step of treating the substrate surface with plasma after the banks and/or imprint formations are formed. Exemplary plasma treatment includes exposure to argon plasma, atmospheric plasma, ultraviolet light, ozone, oxygen plasma, peroxides or other oxidizing species. The plasma may aid in the removal of excess polymeric material from the substrate surface. For example, any polymeric material that may be disposed on the well region may be removed using plasma treatment.

The method may comprise the step of treating the banks and/or imprint formations with a fluorinated compound in order to adjust the wetting property of the banks and/or imprint formations. For example, a fluorinated gas may be used to further increase the hydrophobicity of the banks and/or imprint formations.

The material of the substrate surface may be selected from the group consisting of glass, ceramic, silicon, quartz, metal and plastic.

The substrate surface may further comprise an electrode. The electrode may be deposited on the substrate surface before the formation of banks and imprint formations. Alternatively, the electrode may be deposited on the substrate surface after the banks and imprint formations are formed. The electrode may be deposited through means such as vacuum deposition, sputtering, electron beam deposition, ion plating, plating, thermocompression bonding or chemical vapor deposition. The electrode may be an anode or a cathode. The electrode may be cross-linked to the polymeric material.

The anode may be a conductive layer which serves as a hole-injecting layer and comprises a material with a work function greater than about 4.5 eV. The material of the anode may be selected from the group consisting of metals, metal oxides, graphite, doped inorganic semiconductors and doped conducting polymers. The metals may be selected from Group IB, Group VIIIB, Group IVA, Group IIA or Group IIB of the Periodic Table of Elements. Exemplary metals may be selected from the group consisting of platinum, copper, silver, nickel, gold, palladium, indium, lead, tin and mixtures thereof. Exemplary metal oxides may be selected from the group consisting of lead oxide, zinc oxide, indium oxide, indium zinc oxide, indium tin oxide, tin oxide, magnesium-indium oxide, cadmium tin oxide and mixtures thereof. The metals or metal oxides may be doped with a suitable dopant. Exemplary doped inorganic semiconductors may be selected from Group IIIA, Group IV or Group VA of the Periodic Table of Elements and may be selected from the group consisting of silicon, germanium, gallium arsenide and mixtures thereof. Exemplary doped conducting polymers may be selected from the group consisting of polyaniline, polypyrrole, polythiophene, conjugated polymers, copolymers and derivatives thereof.

The thickness of the anode may be usually in the range of about 50nm to about 500nm, preferably about 100 nm to about 300nm, more preferably about 120nm to about 250nm.

The cathode may be a conductive layer which serves as an electron-injecting layer and which comprises a material with a low work function. The material of the cathode may be a metal selected from Group IA, Group IIA, Group IIIB, Group IVB, Group VB, Group VIB, Group VIIB, Group VIIIB, Group IB, Group IIB, Group IIIA or Group IVA of the Periodic Table of Elements. Exemplary cathode material may be selected from the group consisting of lithium, sodium, potassium, aluminum, silver, magnesium, manganese, calcium, barium, indium, gold, rubidium, cesium, beryllium, strontium, scandium, vanadium, zinc, yttrium, cerium, samarium, europium, terbium, ytterbium, platinum, copper, manganese, titanium, cobalt, nickel, tungsten, tin, alloys and combinations thereof. The cathode may be graphite or graphite interlayer compounds. The cathode may be made of two layers to enhance electron injection.

The thickness of the cathode may be usually in the range of about 50nm to about 500nm, preferably about 60nm to about 300nm, more preferably about 70nm to about 200nm.

The substrate and the electrodes may be transparent to allow light to pass through.

The dimensions of the banks, imprint formations and wells may be in the microscale or in the nanoscale.

The height of the banks may be usually in the range of about 0.1 µm to about 10 µm, preferably about 0.3 µm to about 8 µm, more preferably about 0.5 µm to about 4 µm.

In one embodiment, the height of the first set of imprint formations correspond with the height of the banks. Accordingly, in this embodiment, the height of the first set of imprint formations may be usually in the range of about 0.1 µm to about 10 µm, preferably about 0.3 µm to about 8µm, more preferably about 0.5 µm to about 4 µm.

The first set of imprint formations and second set of imprint formations may have different width dimensions relative to each other.

The width of the first set of imprint formations may be usually in the range of about 10 µm to about 1000 µm, preferably about 20 µm to about 800µm, more preferably about 30 µm to about 500 µm.

The width of the second set of imprint formations may be usually in the range of about 0.1 µm to about 100 µm, preferably about 0.15 µm to about 50pm, more preferably about 0.2 µm to about 30 µm.

The imprint formations on the banks of the substrate surface confer an anisotropic wetting property to the banks that is substantially different from the wetting property of the wells alternating therebetween the banks. The selected wetting property may be hydrophobicity or hydrophilicity.

The difference in the wetting property between the banks and the wells may aid in the deposition of the organic solution. The imprint formations results in the banks becoming more anisotropic hydrophobic as compared to the surface of the wells. When an organic solution having hydrophilic wetting ability is deposited onto the substrate surface, the organic solution may be at least partially repelled by the hydrophobic nature of the banks and deposit in the wells, which are hydrophilic as compared to the banks.

The imprint formations may aid in the passage of organic solution between subsequent wells that are disposed along a longitudinal axis. For example, when an excess of organic solution is deposited in a first well, the excess organic solution may overflow into the imprint formations. Due to the difference in the wetting property of the imprint formations and the wetting ability of the organic solution, the organic solution is repulsed by the imprint formations and hence, flows along the imprint formations to an adjacent well.

After the banks and imprint formations are formed, an organic solution may be deposited into the well formations. The organic solution may be deposited through means such as, but not limited to, inkjet printing, spin coating, dip coating, roll coating, spray-coating, blade coating, flexographic printing or screen printing.

The imprint formations on the banks may allow the organic solution to be deposited in the well formations by inkjet printing without substantial smearing or interaction between organic solutions in adjacent wells. Hence, the imprint formations may aid in the positioning of each of the plurality of organic solutions to individual wells.

A plurality of sprays containing said organic solution may be deposited at the same time on the substrate surface, such as by a printhead of a conventional inkjet printing system. Furthermore, an array of fluid-emitting conduits present on the printhead may emit different types of organic solution to particular areas of the substrate. For example, in the manufacture of a OLED, one set of fluid-emitting conduits of the print head may emit one organic solution containing an organic light emitting compound of a first color to a first set of wells while simultaneously, another set of fluid-emitting conduits may emit another organic solution containing organic light emitting compounds of a second color to a second set of wells. Furthermore, a plurality of organic solutions may be deposited through a plurality of cartridges or print-heads in the inkjet printer.

The plurality of organic solutions may be of the same type or may be of a different type as compared to each other. When a plurality of different organic solutions is to be deposited, the different organic solutions may have similar wetting ability.

In other embodiments where the same organic solution is to be deposited in all of the wells, inkjet printing or spin coating may be used as the depositing means. When spin coating is used, the presence of the imprint formations may aid in the positioning of the organic solution in the wells after the organic solution is partially repelled by the imprint formations.

The method may comprise the step of allowing the organic solution to dry or evaporate in order to form a layer in the wells.

The method may comprise the step of repeating the depositing step and evaporating step in order to form more than one layer in a well or to increase the amount of organic compound present in the well.

In embodiments where more than one layer is to be deposited in a well, the depositing step may be the same or may be different. For example, a first layer may be deposited through spin coating and a second layer may be deposited by inkjet printing.

The organic solution may comprise a substantially homogeneous mixture of an organic compound in a suitable solvent. The solvent may be selected according to the solubility of the organic compound and the type of deposition means. The method may comprise a filtration step in order to remove any un-dissolved organic compound. This may aid in downstream processing. For example, if the organic solution is deposited using inkjet printing, filtering the organic solution may aid in minimizing clogging of the print-heads.

The organic compound may be an active material that may be integral to the operation of the organic electronic or optoelectronic device. The organic compound may be a light emitting organic molecule, a conductive polymer with hole-transporting properties, an organic material with electron transporting properties, a light emitting polymer, a light absorbing polymer or combinations thereof. The above polymers may be at least partially or fully conjugated. In one embodiment, an organic compound may be a conductive polymer with light emitting properties. In another embodiment, an organic compound may be a conductive polymer with light absorbing properties. The use of the organic compound depends on the type of organic electronic or optoelectronic device.

In an organic transistor the organic compound may be a conductive polymer. In a photovoltaic device, the organic compound may have conductive and light absorbing properties.

The organic light emitting device or polymer light emitting device has usually an anode, a cathode, and a emitting layer and has further (a) an electron-transporting layer between the cathode and emitting layer (having the anode, the emitting layer, the electron-transporting layer, and the cathode in that order), (b) a hole-transporting layer between the cathode and the emitting layer (having the anode, the hole-transporting layer, the emitting layer, and the cathode in that order), or (c) an electron-transporting layer between the anode and the emitting layer and a hole-transporting layer between the anode and the emitting layer (having the anode, the hole-transporting layer, the emitting layer, the electron-transporting layer, and the cathode in that order). For example, the light, emitting device (c) may be produced by a method in which the anode, the hole-transporting layer, the emitting layer, and the electron-transporting layer are formed on the foregoing substrate in order, the resulting laminate and the other foregoing substrate on which the cathode is formed are overlaid with each other such that the electrodes (the anode and the cathode) lie at both ends, and the ends are sealed. In this method, either the substrate with the anode or the substrate with the cathode is transparent.

The light emitting organic molecule may be, but not limited to, polymers that are suitable for use in an organic electronic or optoelectronic device in the view of stability after coating.

The hole-transporting layer may comprise a conductive polymer selected from the group consisting of polyvinyl carbazole, polyvinyl carbazole derivatives, polysilane, polysilane derivatives, polysiloxane derivatives having aromatic amine compound groups on side chains or main chains, polyaniline, polyaniline derivatives, polythiophene, polythiophene derivatives, poly (p-phenylenevinylene), poly (p-phenylenevinylene) derivatives, poly (2, 5-thienylenevinylene), and poly (2, 5-thienylenevinylene) derivatives. The hole-transporting layer may be formed by means of inkjet printing, spin coating, dip coating, roll coating, spray-coating, blade coating, flexographic printing or screen printing.

The emitting layer may be made of an organic EL material, and may be made of either low-molecular compounds or high-molecular compounds. Examples of the low-molecular compounds include naphthalene derivatives; anthracene; anthracene derivatives; perylene; perylene derivatives; dyes such as polymethine dyes, xanthene dyes, coumarin dyes, and cyanine dyes; 8-hydroxyquinoline; metal complexes of 8-hydroxyquinoline derivatives; aromatic amine; tetraphenylcyclopentadiene; tetraphenylcyclopentadiene derivatives; tetraphenylbutadiene; and tetraphenylbutadiene derivatives (JP-A Nos. 57-51781 and 59-194393). The emitting layer may be formed by vacuum deposition (powder is used the material) or inkjet printing, spin coating, dip coating, roll coating, spray-coating, blade coating, flexographic printing or screen printing.

Examples of the high-molecular compounds include poly (p-phenylenevinylene), polyfluorene, and polyparaphenylene derivatives (Jpn. J. Appl. Phys. (1991), vol. 30, p. L1941 and Adv. Mater. (1992), vol. 4, p. 36).

The electron-transporting layer may comprise an organic material selected from the group consisting of oxadiazole derivatives, anthraquinodimethane, anthraquinodimethane derivatives, benzoquinone, benzoquinone derivatives, naphthoquinone, naphthoquinone derivatives, anthraquinone, anthraquinone derivatives, tetracyanoanthraquinodimethane, tetracyanoanthraquinodimethane derivatives, fluorenone derivatives, diphenyldicyanoethylene, diphenyldicyanoethylene derivatives, diphenoquinone derivatives, 8-hydroxyquinoline, metal complexes of 8-hydroxyquinoline derivatives, polyquinoline, polyquinoline derivatives, polyquinoxaline, polyquinoxaline derivatives, polyfluorene, and polyfluorene derivatives. The electron-transporting layer may be formed by vacuum deposition (powder is used as the material) or inkjet printing, spin coating, dip coating, roll coating, spray-coating, blade coating, flexographic printing or screen printing (a solution is used as the material).

The light absorbing polymer may be a polymer selected from the group consisting of poly(pyridine), poly(pyrazine), poly(pyridine vinylene), or poly(pyrazine vinylene), poly-3-hexylthiophene, copolymers, derivatives and mixtures thereof.

The thickness of the organic layer may be usually in the range of about 2nm to about 300nm, preferably about 5nm to about 200nm, more preferably about 10nm to about 150nm.

The solvent used to dissolve the organic compound depends on the type of organic compound. The solvent may be an organic solvent. Exemplary types of solvents include, but not limited to, water, anisole, toluene, xylene, benzene, mesitylene, chloroform, dichloromethane, cyclohexylphenol, ethanol, tetrahydronaphthalene, tetrahydrofuran, isopropyl alcohol and mixtures thereof. The organic solution may comprise a substantially homogeneous mixture of an organic compound in a suitable solvent.

After the relevant organic solutions are deposited into the wells and layered, a second electrode may be placed on top in order to complete the circuit for electricity to flow through the layered organic solutions. The second electrode may be deposited through means such as vacuum deposition or sputtering. In one embodiment, the organic solutions are deposited on the anode and a cathode is place on top of the layered organic solutions. The longitudinal axis of the cathode may be placed perpendicular to the longitudinal axis of the anode. In another embodiment, the cathode may be a flat sheet that substantially covers the entire device.

A secondary substrate may be placed on top of the second electrode. The substrates and electrodes may be transparent to allow light to pass through and from the device.

A source of electricity may be integrated with the above device in order to supply electricity to the wells. It is to be noted that a well may also be used to refer to a pixel.

Also disclosed herein is a method of making a substrate, the method comprising the steps of: (a) providing a substrate having a polymer layer formed thereon; and (b) applying at least one mold to said polymer layer to form a plurality of banks thereon with alternating well formations formed between said banks, said at least one mold having imprint forming surfaces thereon to form imprint formations on said bank surface which confer a selected wetting property to the surface of said banks that is different from the surface of said wells.

The mold may have a pattern that aids in creating the banks and imprint formations from the polymer layer. For example, where banks are intended to be present on the substrate surface, the mold may have corresponding depressed regions on the mold surface in order to make the banks after the mold is applied to the polymer layer.

The mold may be made from a material selected from the group consisting of silicon, metal, glass, quartz, ceramic and combinations thereof.

The mold may be applied to the polymer layer in order to form banks. More than one mold may be applied to the polymer layer to form banks and imprint formations. In one embodiment, a single mold may have a pattern that corresponds to the banks and imprint formations that are to be formed on the substrate surface. In another embodiment, a first mold having a pattern that corresponds to the banks may be applied to the polymer layer first. Subsequently, a second mold having a pattern that corresponds to the imprint formations may be applied to the banks that have been formed on the substrate surface.

The imprint formations may be of any shape. Exemplary shapes are gratings, trenches, squares, rectangles, circles, holes or pillars.

In embodiments where more than one mold is used, the subsequent molds may be applied at an angle relative to the first mold. The application of subsequent molds at an angle relative to the first mold may aid in the selection of a desired wetting property that is to be conferred to the banks.

The mold may be applied to the substrate surface at a temperature that is above the glass transition temperature (Tg) of the polymeric material in the polymer layer. At this temperature, the polymeric material softens and may conform to the shape of the mold such that banks are formed from the polymeric material. In one embodiment, banks and imprint formations may be formed in one step when one mold is applied onto the substrate surface. The mold may be applied at a predetermined pressure for a certain period of time to form the banks and imprint formations. The temperature and pressure to be applied will be dependent on the type of polymeric material used in the polymer layer. Exemplary types of polymeric material used for forming the banks and imprint formations are disclosed above.

The temperature used when applying a first mold to the polymeric material may be selected from the group consisting of about 60°C to about 200°C, about 60°C to about 180°C, about 60°C to about 160°C, about 60°C to about 140°C, about 60°C to about 120°C, about 60°C to about 100°C, about 60°C to about 800°C, about 80°C to about 200°C, about 100°C to about 200°C, about 120°C to about 200°C, about 140°C to about 200°C, about 160°C to about 200°C about 180°C to about 200°C.

The pressure used when applying a first mold to the polymeric material may be selected from the group consisting of about 40 bars to about 50 bars, about 42 bars to about 50 bars, about 44 bars to about 50 bars, about 46 bars to about 50 bars, about 48 bars to about 50 bars, about 40 bars to about 42 bars, about 40 bars to about 44 bars, about 40 bars to about 46 bars and about 40 bars to about 48 bars.

The time period used when applying a first mold to the polymeric material may be in the range of about 4 minutes to 20 minutes.

In embodiments where more than one mold is applied to the polymeric material, during the step of applying a second mold, the method may comprise the step of selecting a temperature that is below the glass transition temperature (Tg) of the polymeric material.

The temperature used when applying a second mold to the polymeric material may be selected from the group consisting of about 60°C to about 120°C, about 80°C to about 120°C, about 100°C to about 120°C, about 60°C to about 80°C and about 60°C to about 100°C.

The pressure used when applying a second mold to the polymeric material may be selected from the group consisting of about 10 bars to about 50 bars, about 15 bars to about 50 bars, about 20 bars to about 50 bars, about 25 bars to about 50 bars, about 30 bars to about 50 bars, about 35 bars to about 50 bars, about 40 bars to about 50 bars, about 45 bars to about 50 bars, about 10 bars to about 15 bars, about 10 bars to about 20 bars, about 10 bars to about 25 bars, about 10 bars to about 30 bars, about 10 bars to about 35 bars, about 10 bars to about 40 bars and about 10 bars to about 45 bars.

The time period used when applying a second mold to the polymeric material depends on the temperature used in the imprinting step and the depth of imprint required. For example, a lower temperature requires a longer time period while a smaller imprinting depth requires a shorter time period. Exemplary range of time period is from about 10 minutes of about 30 minutes.

In one embodiment, the method may comprise, after applying a second mold, the step of applying one or more further imprint formations on the banks, wherein the one or more further imprint formations are at a different orientation or at a similar orientation to at least the second imprint.

The mold may be used repeatedly without any substantial transfer of material between the mold and the polymeric material. Hence, contamination to either the mold or polymeric material may be minimized or eliminated.

### Brief Description Of Drawings

The accompanying drawings illustrate a disclosed embodiment and serves to explain the principles of the disclosed embodiment. It is to be understood, however, that the drawings are designed for purposes of illustration only, and not as a definition of the limits of the invention.
Fig. 1 is a schematic diagram of a method for forming banks and imprint formations on a substrate surface according to a disclosed embodiment.
Fig. 2 is a schematic diagram of a method for forming banks and imprint formations on a substrate surface according to another disclosed embodiment.
Fig. 3 is a cross-sectional view of a mold used to form the banks and imprint formations in a single molding step.
Fig. 3A is a close-up of part of the mold disclosed in Fig. 3.
Fig. 4 is a cross-sectional view of an organic electronic device 50 formed according to a disclosed embodiment for deposition of organic solution using inkjet printing.
Fig. 5A is a top view of a substrate surface with imprint formations incorporated into banks for directing flow of organic solution between wells.
Fig. 5B is a perspective view of the substrate surface of Fig. 5A with deposition of organic solution using inkjet printing.
Fig. 6A is an atomic force microscope three-dimensional image of a representative hierarchical structures, wherein the first set of longitudinally-shaped imprint formations are perpendicular to the second set of longitudinally-shaped imprint formations. The scale for this figure is 10 µm per division for the x axis and 700 nm per division for the z axis.
Fig. 6B is an atomic force microscope at a resolution of three-dimensional image of a representative hierarchical structures, wherein a set of longitudinally-shaped imprint formations are disposed thereon. The scale for this figure is 2 um per division for the x axis and 700 nm per division for the z axis.

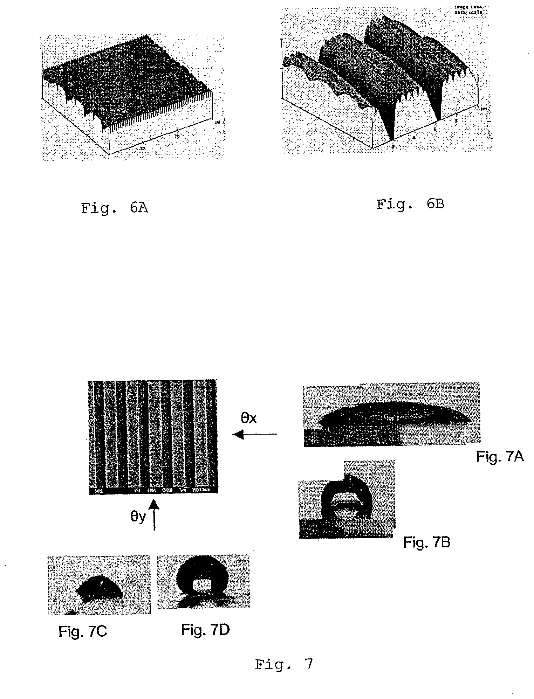

Fig. 7 is a collective diagram of two types of solvent placed on an imprinted surface that is representative of the imprint formations incorporated into the banks. Fig. 7A is an optical image of an anisole droplet placed on the imprinted surface depicted in Fig. 7 taken from the θₓ-direction; Fig. 7B is an optical image of a water droplet placed on the imprinted surface depicted in Fig. 7 taken from the θₓ-direction; Fig. 7c is an optical image of an anisole droplet placed on the imprinted surface depicted in Fig. 7 taken from the θ_{y}-direction; and Fig. 7D is an optical image of a water droplet placed on the imprinted surface depicted in Fig. 7 taken from the θ_{y}-direction.

### Detailed Disclosure of Embodiments

Non-limiting embodiments will be further described in greater detail by reference to the following Examples described further below, which should not be construed as in any way limiting the scope of the invention.

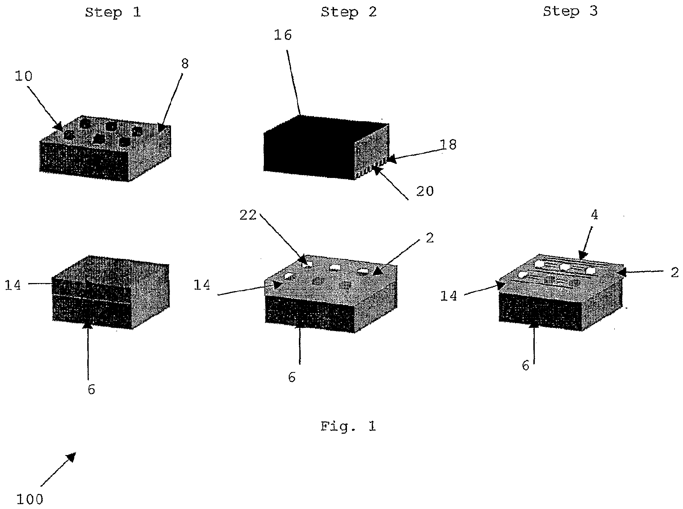

Fig. 1 is a schematic diagram of a method 100 according to a disclosed embodiment.

In the first step, a substrate 6 having a layer of polymeric material 14 is stamped with a first mold 8 using an Obducat nanoimprinter. The first mold 8 has mold forming imprints in the form of columns 10 disposed on the surface of the first mold 8. As can be seen in Step 2, the first mold 8 makes an impression in the layer of polymeric material 14 to form wells 22 by the corresponding columns 10 of the first mold 8. The first mold 8 is applied at a temperature above the T_{g} of the polymeric material 14. The wells 22 are surrounded by banks 2.

In step 3, a second mold 16 having gratings 18 and trenches 20 is stamped onto the banks 2 to form imprint formations 4 on the surface of the banks 2. The second mold 16 makes an impression in the top surface of the banks 2 by the corresponding trenches 20 and gratings 18. The second mold 16 is applied to the banks 2 using an Obducat nanoimprinter at a temperature below the T_{g} of the polymeric material 14. The mold 16 is stamped onto the banks 2 such that the longitudinal axis of each of the imprint formations 4 is parallel with the longitudinal axis of the banks 2.

As will be shown in more detail with respect to the specific examples below, the method 100 results in a substrate 6 having well formations 22 alternating between banks 2 and imprint formations 4, wherein the imprint formations 4 confer an anisotropic wetting property to the surface of the banks 2 that is different from the surface of the well formations 22.

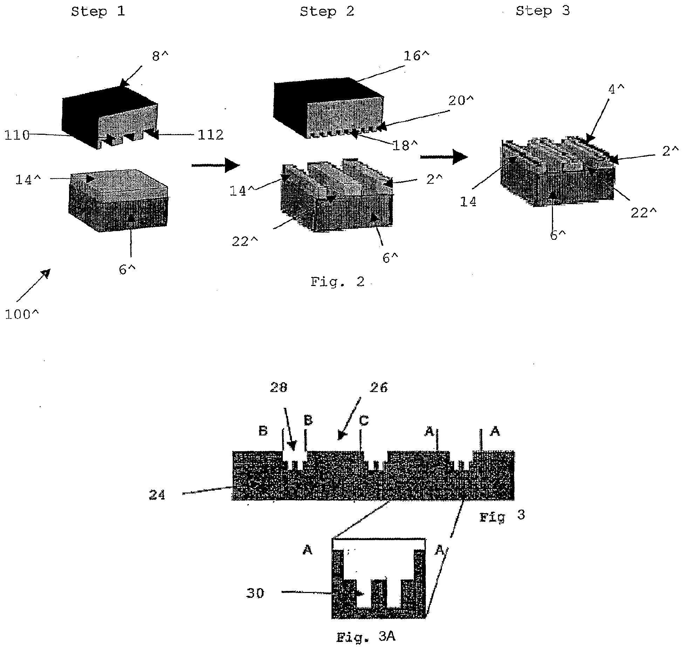

Fig. 2 is a schematic diagram of a method 100^ according to another disclosed embodiment. The method 100^ depicted in Fig. 2 is similar to the method 100 of Fig. 1 and thus like elements are labeled with like reference numerals followed by a capped (^) symbol.

In the first step, a substrate 6^ having a layer of polymeric material 14^ is stamped with a first mold 8^ using an Obducat nanoimprinter. The first mold 8^ has mold forming imprints in the form of gratings 110 and trenches 112. As can be seen in Step 2, the first mold 8^ makes an impression in the layer of polymeric material 14^ to form the banks 2^ by the corresponding trenches 112 of the first mold 8^ and wells 22^ by the corresponding gratings 110 of the first mold 8^. The first mold 8^ is applied at a temperature above the T_{g} of the polymeric material 14^. Hence, a series of banks 2^ disposed parallel to each other are provided on the substrate 6^ with alternating wells 22^ disposed therebetween.

In step 3, a second mold 16^ having gratings 18^ and trenches 20^ is stamped onto the banks 2^ to form imprint formations 4^ on the surface of the banks 2^. The second mold 16^ makes an impression in the top surface of the banks 2^ by the corresponding trenches 20^ and gratings 18^. The second mold 16^ is applied to the banks 2^ using an Obducat nanoimprinter at a temperature below the T_{g} of the polymeric material 14^. The mold 16^ is stamped onto the banks 2^ such that the longitudinal axis of each of the imprint formations 4^ is parallel with the longitudinal axis of the banks 2^.

It can be seen that the shape of the wells 22^ in Fig. 2 is different from the shape of the wells 22 in Fig. 1.

Fig. 3 is a cross-sectional view of a mold 24 used to form the banks and imprint formations at the same time. Fig. 3A is a close-up of part A-A of mold 24 disclosed in Fig. 3. The mold 24 determines the regions of well formations, bank and imprint formations on a substrate surface. When mold 24 is applied onto a substrate surface, the region 26 between lines B-C of mold 24 results in well formations on the substrate surface. The region 28 between lines B-B of mold 24 results in banks on the substrate surface and patterns 30 of mold 24 results in imprint formations on the banks on the substrate surface.

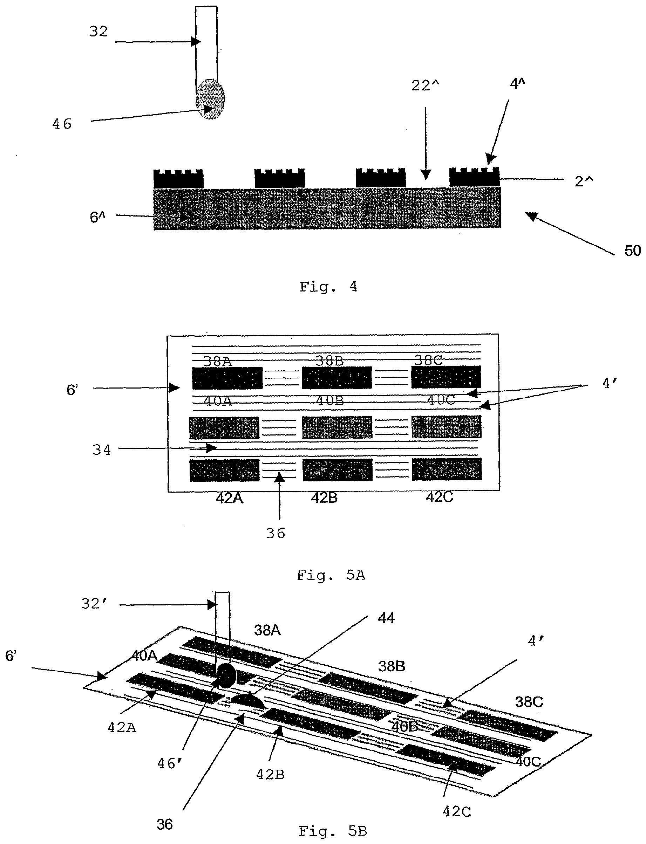

Fig. 4 is a cross-sectional view of an organic electronic device 50 formed according to the method 100^ of Fig. 2. The electronic device 50 comprises a substrate 6^ with well formations 22^ and banks 2^ with imprint formations 4^ thereon. An inkjet cartridge or print-head 32 is used to deposit an organic solution 46 into the well. formations 22^. The solvent of the organic solution 46 will be chosen such that should any organic solution fall on the imprint formations 4^ of the banks 2^, the wetting property of the imprint formations 4^ repels the organic solution 46 so that it resides in the well formations 22^. Hence, the anisotropic property of the imprint formations 4^ inhibits spreading of the organic solution 46 from the well formations 22^.

Fig. 5A is a top view of a substrate 6' with imprint formations 4' incorporated onto the banks for directing flow of organic solution. It is to be noted that the substrate 6' is functionally similar to that depicted in Fig. 4 and is labeled with like reference numerals followed by a prime (') symbol. Well set (38A,38B,38C) contain blue-coloured organic solution; well set (40A,40B,40C) contain green-coloured organic solution and well set (42A,42B,42C) contain red-coloured organic solution. The presence of the imprint formations 4' aids in preventing the cross-contaminations of organic solutions between well set (38A,38B,38C), well set (40A,40B,40C), and well set (42A, 42B, 42C). For example, if the organic solution lands in the region denoted by the numeral 34 in Fig. 5A, the organic solution may travel along the imprint formations 4' to the end of the substrate surface. The organic solution present in the region 34 may not travel perpendicularly to the imprint formations 4' and deposit into an adjacent well with a differently coloured organic solution. If an organic solution lands in the region denoted by the numeral 36 in Fig. 5A, the organic solution may travel along the imprint formations 4' in the direction towards, for example, well 42B, and deposit into a well along its path of travel, such as well 42B. Accordingly, the presence of imprint formations 4' may aid in the positioning of the various coloured organic solutions into their respective wells.

Fig. 5B is a perspective view of the substrate 6' of Fig. 5A with deposition of organic solution 46' using inkjet printing 32'. As discussed above, if the organic solution 44 deposits in region 36, the organic solution 44 travels along the imprint formations 4' towards well 42B and subsequently, deposits in well 42B.

Fig. 6A is an atomic force microscope three-dimensional image of a representative hierarchical structures, wherein the first set of imprint formations are perpendicular to the second set of imprint formations.

Fig. 6B is an atomic force microscope three-dimensional image of a representative hierarchical structures, wherein the first set of imprint formations are parallel to the second set of imprint formations.

It can be observed from Fig. 6A and Fig. 6B that the imprint formations result in a change in the top surface of the banks in terms of morphology and topography.

### Preparation of substrate and polymeric material

Referring to Fig. 1, the polymeric material 14 was spin coated onto a substrate 6. SU-8™ 2000 resist was used as the polymeric material 14 and a silicon wafer with a layer of indium tin oxide was used as the substrate 6. The substrate 6 was treated in an oxygen plasma at 80W and 250 Torr for 10 minutes. SU-8™ 2002 resist was originally formulated in cyclopentanone and used as received. The spin coating conditions used were formulated to give a film thickness of 2 µm. Approximately 1 ml of SU-8™ 2002 resist solution was used per 1 cm by 1 cm area of substrate. The spread cycle was 500 rpm at 100 r/s for 5 seconds. The spin cycle was 3000 rpm at 300 r/s for 30 seconds. After the SU-8™ 2002 resist had been applied to the substrate 6, the resultant sample was then soft baked at 65°C for 5 minutes and then at 95°C for 5 minutes to evaporate the solvent and to densify the film. The samples were baked on a digital level hotplate.

### Treatment of mold

The molds (8,16) used for the imprinting process were made of silicon and are commercially available. For example, the molds may be obtained from NTT Advanced Technology Corporation (NTT-AT) of Japan or from NIL Com of Germany. The molds (8,16) were cut into appropriate sizes of 2 cm by 2 cm by a diamond scribe. The molds (8,16) were then cleaned by sonicating in acetone and then isopropanol for 10 minutes. The molds (8,16) were further treated in an oxygen plasma at 80W and 250 Torr for 10 minutes. After treatment, the molds (8,16) were treated with 20mM solution of perfluorodecyltrichlorosilane (FDTS) for half an hour in a nitrogen glovebox. The relative humidity in the glove box was kept between 10 to 15 %. The molds (8,16) were then rinsed with heptane and isopropanol respectively. The molds (8,16) were soft-baked for 1 hour in an oven at 95°C to remove any residual solvent. Prior to imprinting, all the molds (8,16) used were cleaned again by sonicating with acetone and isopropanol for 10 minutes and then dried with nitrogen before use.

### Imprinting Conditions

Imprinting was carried out on an Obducat imprinter (Obducat Sweden). In Step 1 of Fig. 1, the mold 8 was placed on top of the substrate 6 and loaded into the imprinter. SU-8™ 2002 as the polymeric material 14 was imprinted at 90°C at 60 bars for 10 minutes in order to form the banks 2 on the surface of the substrate 6 as depicted in Step 2. In Step 2, the mold 16 was placed on top of the banks 2 to form the imprint formations 4 incorporated into the banks 2. The imprinting conditions for this step is 40°C at 60 bars for 10 minutes.

### Cross-linking conditions

To cross link the polymeric material with the indium tin oxide present in the anode layer, the samples were then exposed to UV light in the imprinter for 10 seconds. The samples were then baked in a convection oven at 180°C for 2.5 hours. The temperature was reduced slowly to allow the samples to cool gradually. This is to prevent thermal stress from occurring in the sample. The samples were then demolded to separate the mold from the substrate.

### Measurement of contact angle

Contact angle measurements were carried out using a ramé-hart goniometer from rame-hart of Mountain Lakes, New Jersey, United States of America. A small deionised water droplet was first placed gently on the sample surface by an automatic pipette and then a photograph of the water droplet sitting on the polymer surface was taken and analyzed. For each sample, 3 to 6 points were examined. At times, there may be a need to measure the contact angle manually by drawing a tangent on the printout photograph of the water droplet when the goniometer gives unreasonable results due to occasional imperfections on the image of samples.

### Types of solvent investigated

Two types of solvents were investigated, water and anisole. Water is a commonly used solvent for the semiconducting polymer such as polyethylenedioxythiophene, while anisole was included as it is a commonly used solvent in a number of semiconducting and light-emitting polymers.

Fig. 7 is a representative diagram of a water droplet and an anisole droplet placed on an imprinted surface with protrusions and depressions of width 2 µm that is indicative of the imprint formations at 5000x magnification. The contact angle measurements were taken from two directions as shown in Fig. 7. θx refers to the contact angle measured in the "X" direction being perpendicular to the longitudinal axis and θy refers to the contact angle measured in the "Y" direction parallel, or in alignment with, the longitudinal axis.

As seen in Fig. 7A and Fig. 7C, the anisole droplet shows hydrophilic wetting with anisotropic properties. As seen in Fig. 7B and Fig. 7D, the water droplet exhibits hydrophobic wetting with isotropic properties.

### Example 1

The contact angles of water and anisole on a SU-8™ 2000 resist material are discussed in this example.

As discussed above, the SU-8™ 2000 resist was used as the polymeric material to make the banks to direct positioning of organic solutions into the respective wells. The banks comprising SU-8™ 2000 resist were imprinted with imprint formations of gratings and trenches of width and height 2 µm. The contact angles (θx, θy) and change in contact angle (Δθ) for water and anisole are shown in Table 1.

**Table 1: Contact angle measurements of water and anisole**

| | Water | | | Anisole. | | |
|---|---|---|---|---|---|---|
| | *θ*ₓ (°) | *θ*_{y} (°) | Δ*θ* (°) | *θ*ₓ (°) | *θ*_{y} (°) | Δ*θ* (°) |
| Flat/nonpatterned (post-cured*) | 87.7 | 86.9 | ∼0 | 29.6 | 31.6 | ∼0 |
| **2 µm (post-cured*)** | 137.9 | 83.2 | 54.7 | 28 | 21 | 7 |

| | | | | | | |
|---|---|---|---|---|---|---|
| * The term "post-cured" refers to the state of the SU-8™ 2000 resist as a result of the processing conditions. The SU-8™ 2000 resist was first exposed to UV light to initiate the cross-linking process and then heated up to complete the crosslinking. The SU-8™ 2000 resist at this stage is known as "post-cured". | | | | | | |

As seen from Table 1, water becomes more hydrophobic (θx=137.9) and more anisotropic (Δθ changes from 0° to 54.7°) when placed on an imprint formation of trenches and gratings of width and height of 2 µm. Furthermore, additional imprint formations may be incorporated into the 2 µm imprints. The existence of imprint formations (2 µm) aids in increasing the hydrophobicity and degree of anisotropy of the banks. Therefore, this may aid in the repelling of water molecules from the banks and into the wells.

As seen in Table 1, anisole is a highly wettable liquid as evidenced from the smaller values in the contact angles as compared to water. The imprint formations of gratings and trenches of height and width of 2 µm result in altering the anisotropic property of the SU-8™ resist slightly with respect to anisole.

In order to reduce the wettability of anisole, a surface treatment using oxygen plasma followed by CF₄ was incorporated into SU-8™ 2000 resist. The contact angle measurements of water and anisole after the surface treatment are shown in Table 2 below.

**Table 2: Contact angle measurement of water and anisole after surface treatment.**

| | Water | | | Anisole | | |
|---|---|---|---|---|---|---|
| | *θ*ₓ (°) *θ*ₓ | *θ*_{y}(°) | Δ*θ* (°) | *θ*ₓ (°) | *θ*_{y} (°) | Δ*θ* (°) |
| Flat/No Imprints (Comparative Example) | 116 | 116 | 0 | 56 | 56 | 0 |
| 2 µm width imprint (parallel) | 116 | 120 | 4 | 75 | 26 | 49 |

The surface treatment further increases the contact angles of SU-8™ 2000 resist, making it more hydrophobic as seen from Table 2. More importantly, the surface treatment enhances the degree of anisotropic wetting from Δθ=7 to Δθ=49 when anisole is used.

On the other hand, the surface treatment reduces the anisotropic wetting of water. Therefore, depending on the type of solvent used in the organic solution, suitable surface treatment may be carried out, if necessary.

### Applications

The substrate may be incorporated into an organic light emitting device or a polymer light emitting device whereby a plurality of organic solutions may be deposited on the substrate via inkjet printing.

The imprint formations may aid in substantially reducing the incidence of cross-contamination between organic solutions in adjacent wells when a plurality of organic solutions is deposited using inkjet printing.

The imprint formations may aid in substantially minimizing the occurrence of spreading of organic solutions between wells. This may aid in conferring a higher degree of resolution as compared to current methods, which do not employ imprint formations on the bank structures.

The disclosed method may be employed with deposition means such as inkjet printing. This may be a more cost effective approach than known methods.

The banks and imprint formations on a substrate surface may be made in one step by applying a single mold to the substrate surface in order to confer a selected wetting property onto the banks. This allows for fewer number of processing steps as compared to prior art methods which may require a number of steps such as an exposing step, a chemical etching step and a removal step in order to form desired patterns on a substrate.

Furthermore, the disclosed method may not require the use of complicated organic solution deposition equipment to form the imprint formations. The disclosed method may also substantially minimize the need for electromagnetic radiation or chemicals, which may be hazardous to health or may contaminate the device unnecessarily.

The organic light emitting device or a polymer light emitting device may be used in, for example, computer displays, information displays in vehicles, television monitors, telephones, printers, illuminated signs, biological applications such as microarrays, tissue engineering or cell patterning.

The photovoltaic device may be used in, for example, solar cells, lasers, photo-detectors, biological applications or opto-couplers.

### References

1. T.Kawase, T.Shimoda, C.Newsome, H.Sirringhaus and R.H.Friend, Thin Solid Films (2003) 438-439, 279-287.
2. J.Z.Wang, Z.H.Zheng, H/W/Li, W.T.S.Huck and H.Sirringhaous, Nature (2004) 3, 171-176.
3. T.R.Hebner, C.C.Wu, D.Marcy, M.H.Lu and J.C. Sturm, Appl.Phys.Lett. (1998) 72, 519.
4. Y.Yang, S-C Chang, J.Bharathan and J.Liu, J.Mater.Sci.Mater.Electron (2000) 11, 89-96.

## Claims

1. A method of manufacturing an organic electronic or optoelectronic device, the method comprising the steps of:
a) providing a substrate having a plurality of banks formed thereon with alternating well formations formed therebetween, the surface of said banks having imprint formations formed thereon, wherein the imprint formations confer an anistropic wetting property to the surface of said banks that is different from the surface of said wells; and
b) depositing an organic solution into said well formations, wherein the anistropic wetting property of said surface of the banks causes any organic solution deposited on an area other than said well formations to be at least partially repelled.

2. A method as claimed in claim 1, wherein said imprint formations are generally longitudinal in shape, each of which extend about a longitudinal axis.

3. A method as claimed in claim 2, wherein said imprint formations comprise a first set of imprint formations extending along longitudinal axes that are parallel to each other and a second set of imprint formations extending along longitudinal axes that are parallel to each other and optionally,
the first set of imprint formations and second set of imprint formations have different width dimensions relative to each other,
and optionally the width of said first and second imprints are in either the microscale or the nanoscale and optionally,
the width of said first imprint formations are in the range selected from 10 µm to 1000 µm and optionally,
the width of said second imprint formations are in the range selected from 0.1 µm to 100 µm.

4. A method as claimed in claim 1, wherein said depositing step (b) comprises depositing by means of at least one of inkjet printing, spin coating, dip coating, roll coating, spray-coating, blade coating, flexographic printing and screen printing.

5. A method as claimed in claim 1, wherein said substrate is a material selected from the group consisting of glass, ceramic, silicon, quartz, metal and plastic.

6. A method as claimed in claim 1, wherein said substrate comprises an electrode.

7. A method as claimed in claim 1, wherein said banks are made from a polymer, optionally
a thermoplastic polymer, optionally.
selected from the group consisting of polymethylmethacrylate, polycarbonate, polystyrene, cycloolefinpolymer, polyimide and combinations thereof.

8. A method as claimed in claim 7, wherein said polymer comprises a photoresist.

9. A method as claimed in claim 1, wherein said organic solution comprises an organic compound selected from the group consisting of a light emitting organic molecule, a conductive polymer with hole-transporting properties, an organic material with electron transporting properties, a light emitting polymer, a light absorbing polymer and combinations thereof.

10. A method as claimed in claim 9, wherein said organic compound is dissolved in a solvent selected from the group consisting of water, anisole, toluene, xylene, benzene, mesitylene, chloroform, dichloromethane, cyclohexylphenol, ethanol, tetrahydronaphthalene, tetrahydrofuran, isopropyl alcohol, and mixtures thereof.

11. A method as claimed in claim 10,
comprising the step of:
c) evaporating solvent of said organic solution that had been deposited on said substrate surface.

12. A method as claimed in claim 11, comprising the step of repeating the depositing step (b) and subsequent evaporating step (c) to deposit multi-layers of organic compound on said substrate surface.

13. A method as claimed in claim 1, comprising the step of substantially removing impurities from said substrate.

14. A method as claimed in claim 13, wherein said step of removing impurities from said substrate comprises removing said impurities using plasma treatment.

15. A method of making a substrate comprising the steps of:
a) providing a substrate having a polymer layer formed thereon; and
b) applying at least one mold to said polymer layer to form a plurality of banks thereon with alternating well formations formed between said banks, said at least one mold having imprint forming surfaces thereon to form imprint formations on said bank surface which confer an anistropic wetting property to the surface of said banks that is different from the surface of said wells.

16. A substrate for use in an organic electronic or optoelectronic device having a plurality of banks formed thereon with alternating well formations formed therebetween, the surface of said banks having imprint formations formed thereon, wherein the imprint formations confer an anistropic wetting property to the surface of said banks that is different from the surface of said wells, wherein when an organic solution is deposited on an area other than said well formations, the anistropic wetting property of said banks causes any organic solution deposited thereon to be at least partially repelled.

## Patentansprüche

1. Verfahren zur Herstellung eines organischen elektronischen oder optoelektronischen Bauelements, wobei das Verfahren die folgenden Schritte umfasst:
a) Bereitstellen eines Substrats, das mehrere Bänke aufweist, die darauf mit dazwischen gebildeten abwechselnden Wannenausbildungen gebildet sind, wobei die Fläche der Bänke darauf gebildete Eindrucksausbildungen aufweist, wobei die Eindrucksausbildungen der Fläche der Bänke eine anisotrope Benetzungseigenschaft verleihen, die sich von der Fläche der Wannen unterscheidet; und
b) Aufbringen einer organischen Lösung in die Wannenausbildungen, wobei die anisotrope Benetzungseigenschaft der Fläche der Bänke bewirkt, dass irgendeine organische Lösung, die auf einem Bereich aufgebracht wird, der sich von den Wannenausbildungen unterscheidet, zumindest teilweise abgestoßen wird.

2. Verfahren nach Anspruch 1, wobei die Form der Eindrucksausbildungen allgemein länglich ist, wobei jede davon sich um eine Längsachse erstreckt.

3. Verfahren nach Anspruch 2, wobei die Eindrucksausbildungen eine erste Menge von Eindrucksausbildungen, die sich entlang von Längsachsen erstrecken, die parallel zueinander sind, und eine zweite Menge von Eindrucksausbildungen umfasst, die sich entlang von Längsachsen erstrecken, die parallel zueinander sind, und wahlweise
die erste Menge von Eindrucksausbildungen und die zweite Menge von Eindrucksausbildungen in Bezug zueinander unterschiedliche Breitenabmessungen aufweisen,
und wahlweise die Breite der ersten und der zweiten Eindrücke entweder im Mikrometerbereich oder im Nanometerbereich liegt, und wahlweise
die Breite der ersten Eindrucksausbildungen im Bereich liegt, der von 10 µm bis 1000 µm ausgewählt wird, und wahlweise
die Breite der zweiten Eindrucksausbildungen im Bereich liegt, der von 0,1 µm bis 100 µm ausgewählt wird.

4. Verfahren nach Anspruch 1, wobei der Schritt des Aufbringens (b) das Aufbringen mittels mindestens einem von Tintenstrahldrucken, Aufschleudern, Tauchen, Walzenauftrag, Spritzen, Rakelstreichverfahren, Flexodruck und Siebdruck umfasst.

5. Verfahren nach Anspruch 1, wobei das Substrat ein Material ist, das von der Gruppe ausgewählt ist, die aus Glas, Keramik, Silizium, Quarz, Metall und Kunststoff besteht.

6. Verfahren nach Anspruch 1, wobei das Substrat eine Elektrode umfasst.

7. Verfahren nach Anspruch 1, wobei die Bänke aus einem Polymer und wahlweise
aus einem thermoplastischen Polymer hergestellt sind,
das von der Gruppe ausgewählt wird, die aus Polymethylmethacrylat, Polycarbonat, Polystyrol, Cycloolefinpolymer, Polyimid und Kombinationen davon besteht.

8. Verfahren nach Anspruch 7, wobei das Polymer ein Photoresist umfasst.

9. Verfahren nach Anspruch 1, wobei die organische Lösung eine organische Verbindung umfasst, die von der Gruppe ausgewählt wird, die aus einem lichtemittierenden organischen Molekül, einem leitfähigen Polymer mit Lochtransporteigenschaften, einem organischen Material mit Elektronentransporteigenschaften, einem lichtemittierenden Polymer, einem lichtabsorbierenden Polymer und Kombinationen davon besteht.

10. Verfahren nach Anspruch 9, wobei die organische Verbindung in einem Lösungsmittel aufgelöst wird, das von der Gruppe ausgewählt wird, die aus Wasser, Anisol, Toluol, Xylol, Benzol, Mesitylen, Chloroform, Dichlormethan, Cyclohexylphenol, Ethanol, Tetrahydronaphthalin, Tetrahydrofuran, Isopropylalkohol und Mischungen davon besteht.

11. Verfahren nach Anspruch 10, das den Folgenden Schritt umfasst:
c) Verdampfen von Lösungsmittel von der organischen Lösung, die auf der Substratfläche aufgebracht wurde.

12. Verfahren nach Anspruch 11, das den Schritt des Wiederholens des Schritts des Aufbringens (b) und des anschließenden Schritts des Verdampfens (c) zum Aufbringen mehrerer Schichten von organischer Verbindung auf der Substratfläche umfasst.

13. Verfahren nach Anspruch 1, das den Schritt des im Wesentlichen Entfernens von Verunreinigungen von dem Substrat umfasst.

14. Verfahren nach Anspruch 13, wobei der Schritt des Entfernens von Verunreinigungen von dem Substrat das Entfernen der Verunreinigungen unter Verwendung von Plasmabehandlung umfasst.

15. Verfahren zum Herstellen eines Substrats, das die folgenden Schritte umfasst:
a) Bereitstellen eines Substrats, das eine darauf gebildete Polymerschicht aufweist; und
b) Anwenden von mindestens einer Form auf die Polymerschicht, um mehrere Bänke mit zwischen den Bänken gebildeten abwechselnden Wannenausbildungen darauf zu bilden, wobei die mindestens eine Form Eindrucksausbildungsflächen darauf aufweist, um Eindrucksausbildungen auf der Bankfläche zu bilden, die der Fläche der Bänke eine anisotrope Benetzungseigenschaft verleihen, die sich von der Fläche der Wannen unterscheidet.

16. Substrat zur Verwendung in einem organischen elektronischen oder optoelektronischen Bauelement, das mehrere darauf gebildete Bänke mit dazwischen gebildeten abwechselnden Wannenausbildungen aufweist, wobei die Fläche der Bänke darauf gebildete Eindrucksausbildungen aufweist, wobei die Eindrucksausbildungen der Fläche der Bänke eine anisotrope Benetzungseigenschaft verleihen, die sich von der Fläche der Wannen unterscheidet, wobei, wenn eine organische Lösung auf einem Bereich aufgebracht wird, der sich von den Wannenausbildungen unterscheidet, die anisotrope Benetzungseigenschaft der Bänke bewirkt, dass irgendeine darauf aufgebrachte organische Lösung zumindest teilweise abgestoßen wird.

## Revendications

1. Procédé de fabrication d'un dispositif organique électronique ou optoélectronique, le procédé comprenant les étapes suivantes :
a) obtenir un substrat ayant une pluralité de talus formés sur celui-ci avec des formations en rigole alternées formées entre eux, la surface desdits talus ayant des formations en impression formées sur celle-ci, dans lequel les formations en impression confèrent à la surface desdits talus une propriété de mouillage anisotrope qui est différente de celle à la surface desdites rigoles ; et
b) déposer une solution organique dans lesdites formations en rigole, dans lequel la propriété de mouillage anisotrope de ladite surface des talus provoque une répulsion au moins partielle de toute solution organique déposée sur une zone autre que lesdites formations en talus.

2. Procédé selon la revendication 1, dans lequel lesdites formations en impression ont une forme globalement longitudinale, et chacune d'elles s'étend selon un axe longitudinal.

3. Procédé selon la revendication 2, dans lequel lesdites formations en impression comprennent un premier jeu de formations en impression s'étendant le long d'axes longitudinaux qui sont mutuellement parallèles et un deuxième jeu de formations en impression s'étendant le long d'axes longitudinaux qui sont mutuellement parallèles, et éventuellement
le premier jeu de formations en impression et le deuxième jeu de formations en impression ont des dimensions en largeur mutuellement différentes,
et éventuellement la largeur desdites première et deuxième impressions sont à l'échelle soit du micromètre soit du nanomètre, et éventuellement
la largeur desdites premières formations en impression est située dans la plage allant de 10 µm à 1000 µm, et éventuellement
la largeur desdites deuxièmes formations en impression est située dans la plage allant de 0,1 µm à 100 µm.

4. Procédé selon la revendication 1, dans lequel ladite étape de déposition (b) comprend une déposition au moyen d'au moins l'un parmi une impression à jet d'encre, un revêtement centrifuge, un revêtement par immersion, un revêtement au rouleau, un revêtement par pulvérisation, un revêtement à la lame, une impression flexographique et une sérigraphie.

5. Procédé selon la revendication 1, dans lequel ledit substrat est un matériau choisi dans l'ensemble constitué par le verre, la céramique, le silicium, le quartz, le métal et le plastique.

6. Procédé selon la revendication 1, dans lequel ledit substrat comprend une électrode.

7. Procédé selon la revendication 1, dans lequel lesdits talus sont faits en un polymère, éventuellement
un polymère thermoplastique, éventuellement
choisi dans l'ensemble constitué par le poly(méthacrylate de méthyle), le polycarbonate, le polystyrène, un polymère d'oléfine cyclique, le polyimide, et leurs combinaisons.

8. Procédé selon la revendication 7, dans lequel ledit polymère comprend un photorésine.

9. Procédé selon la revendication 1, dans lequel ladite solution organique comprend un composé organique choisi dans l'ensemble constitué par une molécule organique luminescente, un polymère conducteur ayant des propriétés de transport de trous, un matériau organique ayant des propriétés de transport d'électrons, un polymère luminescent, un polymère absorbant la lumière, et leurs combinaisons.

10. Procédé selon la revendication 9, dans lequel ledit composé organique est dissous dans un solvant choisi dans l'ensemble constitué par l'eau, l'anisole, le toluène, le xylène, le benzène, le mésitylène, le chloroforme, le dichlorométhane, le cyclohexylphénol, l'éthanol, le tétrahydronaphtalène, le tétrahydrofurane, l'alcool isopropylique, et leurs mélanges.

11. Procédé selon la revendication 10, comprenant l'étape suivante :
c) évaporer le solvant de ladite solution organique qui a été déposée sur ladite surface de substrat.

12. Procédé selon la revendication 11, comprenant l'étape de répétition de l'étape de déposition (b) et de l'étape d'évaporation (c) subséquente pour que de multiples couches de composé organique soient déposées sur ladite surface de substrat.

13. Procédé selon la revendication 1, comprenant l'étape d'élimination substantielle des impuretés dudit substrat.

14. Procédé selon la revendication 13, dans lequel ladite étape d'élimination des impuretés dudit substrat comprend l'élimination desdites impuretés par utilisation d'un traitement au plasma.

15. Procédé de fabrication d'un substrat, comprenant les étapes suivantes :
a) obtenir un substrat ayant une couche de polymère formée sur celui-ci ; et
b) appliquer au moins un moule à ladite couche de polymère pour former une pluralité de talus sur celle-ci avec des formations en rigole alternées formées entre lesdits talus, ledit au moins un moule ayant des surfaces de formation d'empreinte sur celui-ci pour former sur ladite surface des talus des formations en empreinte qui confèrent à la surface desdits talus une propriété de mouillage anisotrope qui est différente de celle à la surface desdites rigoles.

16. Substrat destiné à être utilisé dans un dispositif organique électronique ou optoélectronique ayant une pluralité de talus formés sur celui-ci avec des formations en rigole alternées formées entre eux, la surface desdits talus ayant des formations en impression formées sur celle-ci, dans lequel les formations en impression confèrent à la surface desdits talus une propriété de mouillage anisotrope qui est différente de celle à la surface desdites rigoles, dans lequel, quand une solution organique est déposée sur une zone autre que lesdites formations en talus, la propriété de mouillage anisotrope desdits talus provoque une répulsion au moins partielle de toute solution organique déposée sur ceux-ci.
